Europäisches Patentamt

European Patent Office

Office européen des brevets

(11) Veröffentlichungsnummer: **0 324 123**
**A2**

## (12) EUROPÄISCHE PATENTANMELDUNG

(21) Anmeldenummer: 88120847.4

(22) Anmeldetag: 14.12.88

(51) Int. Cl.⁴: **G11B 11/10 , G11B 13/04 , H01J 37/34 , C23C 14/34**

(30) Priorität: 09.01.88 DE 3800449

(43) Veröffentlichungstag der Anmeldung:
19.07.89 Patentblatt 89/29

(84) Benannte Vertragsstaaten:
DE FR GB IT NL

(71) Anmelder: **LEYBOLD AKTIENGESELLSCHAFT**
**Wilhelm-Rohn-Strasse 25**
**D-6450 Hanau 1(DE)**

(72) Erfinder: **Schultheiss, Eberhard, Dr.**
**Dipl-Phys.**
**Burgberg 1**
**D-6348 Herborn(DE)**
Erfinder: **Wirz, Peter, Dr. Dipl-Phys.**
**Klosterstrasse 5**
**D-6296 Waldernbach(DE)**

(74) Vertreter: **Schickedanz, Willi, Dipl.-Ing.**
**Langener Strasse 68**
**D-6050 Offenbach/Main(DE)**

(54) **Verfahren und Einrichtung zur Herstellung magnetooptischer, speicher -und/oder löschfähiger Datenträger.**

(57) Die Erfindung betrifft ein Verfahren und eine Einrichtung zur Herstellung magnetooptischer, speicher- und loschfähiger Datenträger. Hierbei werden verschiedene chemische Stoffe mittels einer Magnetron-Sputteranlage als Schichten auf einem Substrat (4) aufgebracht. Die anteilsmäßige Zusammensetzung der Schichten wird mit Hilfe einer Veränderung der Magnetfeldstärke des Magnetrons (1) gesteuert. Mittels einer geeigneten Meßeinrichtung (51, 58) wird die Kompensationstemperatur der jeweiligen Schicht gemessen und mit einem gewünschten Wert verglichen. Unterscheiden sich die beiden Kompensationstemperaturen, so kann der gewünschte Wert durch Verstellen der Kathodenspannung $U_c$ eingestellt werden, was wiederum über einen Regler (63) durch Verstellen des Abstands der Magnete (8, 9, 10) des Magnetrons (1) vom Target (6) geschieht.

FIG. 1

EP 0 324 123 A2

## VERFAHREN UND EINRICHTUNG ZUR HERSTELLUNG MAGNETOOPTISCHER, SPEICHER- UND/ODER LÖSCHFÄHIGER DATENTRÄGER

Die Erfindung betrifft ein Verfahren und eine Einrichtung zur Herstellung magnetooptischer, speicher- und/oder löschfähiger Datenträger unter Verwendung verschiedener chemischer Stoffe, wobei diese Stoffe mittels einer Magnetron-Sputter-Anlage als Schichten auf ein Substrat aufgebracht werden.

Die Datenspeicherung auf der Basis magnetooptischer Erscheinungen vereint die Vorteile der magnetischen Datenspeicherung, die darin bestehen, daß Daten auf demselben Träger gelöscht und neu geschrieben werden können, mit den Vorteilen der rein optischen Datenspeicherung, die z. B. in der Vermeidung von ungewollten Datenlöschungen durch Abstürzen des Datenkopfes auf den Datenträger liegen. Außerdem lassen sich mit magnetooptischen Speichern sehr hohe Speicherdichten erzielen, die in der Größenordnung von $5 \times 10^8$ bit/cm² liegen und die Herstellung von Gigabyte-Speicherplatten ermöglichen.

Bei diesem magnetooptischen Speichern macht man sich zunutze, daß polarisiertes Licht beim Durchgang durch ein Magnetfeld (Faraday-Effekt) sowie bei einer Reflexion an einer ferromagnetischen Oberfläche (magnetooptischer Kerr-Effekt) eine Drehung seiner Polarisationsebene erfährt. Die Größe der Drehung der Polarisationsebene ist dabei für ein gegebenes Material eine monotone Funktion der Magnetisierung. Um einen solchen Effekt zu erzielen, wird eine magnetische Schicht aufgesputtert, die vor allem aus binären, ternären oder quaternären Legierungen aus den Elementen der Gruppe der Seltenen Erden ($^{59}$Pr -$^{70}$Yb) und der Gruppe der Übergangsmetalle ($^{26}$Fe -$^{28}$Ni) bestehen (Mark H. Kryder, J. Vac. Sci. Technol., A4 (3), 1986, S. 558). Diese Legierungen werden durch einen dc- oder rf-Sputterprozeß (Hong, Gyorgy, van Dover, Nakahara, Bacon, Gallagher: dc magnetron- and diode-sputtered polycrystalline Fe and amorphous Tb(FeCo) films: Morphology and magnetic properties, J. Appl. Phys. 59 (2), 1986, S. 551 bis 556) in Form eines amorphen Dünnfilms auf geeignete Substrate aufgebracht. Zunächst strebt man eine Curie- sowie Kompensationstemperatur der ferrimagnetischen Schicht an, die um 150 °C liegt. Weiterhin soll der magneto-optische Kerr-Effekt möglichst groß sein. Dies bedeutet, daß der Winkel, um den die Lichtpolarisationsrichtung je nach Orientierung der Magnetisierung des reflektierenden Bereichs zur einen oder anderen Richtung gedreht wird, groß sein soll. Mit einem Laser wird die Schicht bis in den Bereich des Kompensationspunktes des ferrimagnetischen Systems erwärmt und ihm so in einem Magnetfeld eine Orientierung aufgeprägt. Zum Auslesen dieser Information dient Laser-Licht von deutlich geringerer Intensität, aber dafür linearer Polarisation. Seine Orientierung wird infolge des magneto-optischen Kerr-Effekts gedreht. Die Drehrichtung wird mit einem Analysator bestimmt; sie enthält die gespeicherte Information (Hans-Gerd Severin: Sputtern, Die Erzeugung dünner Schichten, Zeitschrift Physik in unserer Zeit, 17. Jahrgang 1986, S. 71 bis 79, insbesondere S. 77/78). Ein großes Problem bei der Herstellung dieser Art magneto-optischer Speicher ist die Oxidationsempfindlichkeit der Schicht. Sie muß daher durch weitere Schichten vor Korrosion und Abrieb geschützt werden. Hierzu dienen in der Praxis Metallschichten oder dielektrische Schichten, z. B. Al, AlN oder $Si_3N_4$.

Während die Ausgangsmaterialien der Legierungen, d. h. die seltenen Erden und die Übergangsmetalle, als solche eine ferromagnetische Ordnung besitzen, weisen die Legierungen dieser Ausgangsmaterialien eine ferrimagnetische Ordnung auf, d. h. die ihrerseits jeweils ferromagnetisch geordneten seltenen Erden und Übergangsmetalle koppeln gegenseitig antiferromagnetisch.

Das Magnetisierungsverhalten der Legierungsschichten entspricht demjenigen von Weichmagneten. Neben einer hohen Squareness (~1) besitzen sie eine starke magnetische Anisotropie von ($k_u \sim 10^6$ erg/cm³) senkrecht zur Schichtoberfläche. Weitere Kenngrößen für das magnetische Verhalten von dünnen Schichten aus Seltenerd- und Übergangsmetallen sind die Koerzitivfeldstärken $H_c$ z.B. bei Raumtemperatur, die Kompensationstemperatur $T_{comp}$ und die Curietemperatur $T_c$. Die Koerzitivfeldstärke ist hierbei als diejenige negative Feldstärke $H_c$ definiert, welche die magnetische Flußdichte B wieder auf Null bringt. Unter der Curietemperatur $T_c$ versteht man diejenige Temperatur, bei der die ferromagnetischen Eigenschaften eines Stoffes verschwinden. Oberhalb der Curietemperatur $T_c$ verschwindet die spontane Magnetisierung völlig, und der vorher ferromagnetische Stoff verhält sich so wie ein paramagnetischer Stoff. Die Kompensationstemperatur $T_{comp}$ ist diejenige Temperatur, bei der die Magnetisierung einer Legierung Null ist, und zwar aufgrund der Addition der positiven Magnetisierung des einen Stoffs der Legierung mit der negativen Magnetisierung des anderen Stoffes der Legierung. Bei der Kompensationstemperatur $T_{comp}$ verschwindet somit die Magnetisierung ebenfalls vollständig, doch verbleibt im Unterschied zur Curietemperatur die magnetische Ordnung der einzelnen Stoffe erhalten.

Da sich Seltenerd- und Übergangsmetalle sowohl bezüglich der Magnetisierungsrichtung als auch in der Temperaturabhängigkeit des Magnetisierungsbetrags unterscheiden, entsteht eine typische Temperaturabhängigkeit der Magnetisierung des Legierungs-Gesamtsystems. Es ist deshalb von großer Wichtigkeit,

EP 0 324 123 A2

den Anteil der Seltenerd- und der Übergangsmetalle innerhalb einer Legierung zu bestimmen oder festzulegen. Es sind bereits Sputtersysteme bekannt, bei denen aus Platten der Einzelelemente zusammengesetzte Targets, sogenannte Mosaiktargets, verwendet werden, um den Seltenerd- und Übergangsmetallanteil in den Legierungsschichten bestimmen zu können. Wie jedoch Untersuchungen an solchen Targets gezeigt haben, gibt es oft herstellungsbedingte Zusammensetzungsfluktuationen. Außerdem verändert sich im Laufe der Targeterosion die Teilchen-Abstrahlcharakteristik der Rennbahnen mit unterschiedlichen Auswirkungen auf die Verteilung der Einzelelemente im Plasma. Diese Effekte führen zu Fluktuationen bzw. zum Langzeit-Driften der hergestellten Funktionsschichten.

Weiterhin ist es bekannt, den jeweiligen Anteil der Ausgangsstoffe durch die Verwendung von entsprechenden Sinter- und Legierungstargets zu bestimmen (H.P.D. Shieh, Dissertation, Carnegy Mellan University, Pittsburg, Cal., USA, 1987). Wie Untersuchungen gezeigt haben, können hierbei die Kompensationstemperatur - und mit ihr die Raumtemperatur-Koerzitivfeldstärken - innerhalb gewissen Grenzen über den Sputtergasdruck und, im Falle des Diodensputterns auch durch einen Substratbias, verändert werden.

Nachteilig ist bei dieser bekannten Methode indessen, daß Änderungen des Prozeßdrucks beim Magnetronsputtern zu unerwünschten Veränderungen der Mikrostruktur der dünnen Legierungsschichten führen. Außerdem sind die spezifischen Raten beim Diodensputtern vergleichsweise gering, und es sind sehr hohe Targetspannungen erforderlich. Weiterhin ist das Anlegen eines Substratbias in einer Produktionsanlage technisch nicht leicht zu lösen und führt im Fall einer rf-Bias häufig zu einer Destabilisierung der Prozesse. Da hierbei zudem hohe Konzentrationen von Ar-Atomen in die Schichten eingebaut werden, sind die magnetischen Eigenschaften der so gewonnenen Legierungsschichten nicht langzeitstabil.

Weiterhin ist es bekannt, zur Vergleichmäßigung des Verbrauchs von Targetplatten die relative Lage von Magnetsystem und Targetplatte laufend zu verändern (DE-OS 27 35 525, DE-OS 30 47 113 bzw. US-PS 4 426 264). Ein Weg, die Zusammensetzung von aufzubringenden Legierungen genau zu bestimmen, ist hierbei jedoch nicht aufgezeigt.

Bekannt ist auch, daß die Winkelverteilung der austretenden Target-Atome bei mehrkomponentigen Targets für die einzelnen Bestandteile unterschiedlich sein kann und daß sich daraus ein Einfluß der Anlagengeometrie auf die Schichtzusammensetzung ergibt (Physik in unserer Zeit, a.a.O., S. 74/75).

Ferner ist eine Zerstäubungskathode bekannt, die sowohl für magnetische als auch für nicht-magnetische Targetmaterialien geeignet ist, die Beschichtung großer Flächen bei laufendem Durchgang der Substrate erlaubt, zu einer sehr gleichmäßigen Schichtdickenverteilung führt und dennoch mit nur einer einzigen Stromversorgung zu betreiben ist (EP 0 253 344 A2). Diese Zerstäubungskathode weist mindestens drei ineinanderliegende Magneteinheiten auf und besitzt eine mechanische Verstelleinrichtung, durch die der magnetische Fluß zwischen einem Magnetjoch und mindestens einer Magneteinheit gegenüber dem magnetischen Fluß zwischen dem Magnetjoch und den übrigen Einheiten veränderbar ist.

Schließlich ist auch noch eine Einrichtung für die Verbesserung des elektrooptischen Effekts eines ferroelektrischen dünnen Films bekannt, der aus Oxiden von Pb, Ti und La zusammengesetzt ist, wobei das molare Verhältnis von Pb zu Ti innerhalb eines speziellen Bereichs festgelegt wird (Patents Abstracts of Japan, June 8, 1984, Vol. 8, No. 122, JP-OS 59-35098). Hierbei werden pulverförmige Oxide von Pb, Ti und La miteinander vermischt, kalziniert und gesputtert, indem das Pulver als Target dient, um einen dünnen Film auf einem Substrat zu bilden. Das molare Verhältnis von Pb zu Ti ist vorzugsweise $0,65 < Pb/Ti < 0,90$. Der elektro-optische Effekt des sich ergebenden ferroelektrischen dünnen Einkristall-Films wird dadurch verbessert und kann als lichtschaltendes Material verwendet werden.

Der Erfindung liegt die Aufgabe zugrunde, die Anteile verschiedener Stoffe, die mit Hilfe einer Magnetron-Anlage auf ein Substrat aufgebracht werden, innerhalb einer Legierung genau zu bestimmen.

Diese Aufgabe wird dadurch gelöst, daß die chemische Zusammensetzung der Schichten durch die jeweilige Einstellung des Magnetfelds des Magnetrons festgelegt wird.

Der mit der Erfindung erzielte Vorteil besteht insbesondere darin, daß sich die jeweiligen Anteile der eine Legierung bildenden Stoffe durch einfache Änderungen des magnetischen Feldes eines Magnetrons regeln lassen. Hierdurch ist es möglich, Fluktuationen bzw. ein Langzeit-Driften in der Zusammensetzung der hergestellten MO( = Magnetooptischen)-Funktionsschichten, welche die Ausnutzung des magnetooptischen Targets begrenzen, auszuregeln. Wird das Magnetfeld der Magnetronkathode abgeschwächt, so steigt der Seltenerdanteil in den hergestellten Legierungsschichten an. Die Magnetfeld-Zusammensetzungscharakteristik ist dabei von der Aperturblendenbreite abhängig. Ist für eine gegebene Targetzusammensetzung der Zusammenhang Koerzitivfeldstärke $H_c$ und Temperatur bekannt, kann durch eine Messung von $H_c$ mittels eines in die Anlage eingebauten Kerrmagnetometers die Zusammensetzung der Schicht bestimmt werden. Mit der Erfindung ist es auch möglich, die Kompensationstemperatur z. B. auf $T_{comp} = 300$ K festzulegen, was ein von vielen Anwendern gewünschter Wert ist.

Die Erfindung nützt auch die Tatsache aus, daß Anlagengeometrie und unterschiedliche Winkelvertei-

3

lungen der Elemente in Legierungstargets beim Sputterprozeß zu Änderungen in der Filmzusammensetzung führen können, indem sie die Zusammensetzungswerte und damit die magnetischen Eigenschaften bei einem magnetischen Dünnfilm gezielt verändert. Dies geschieht auf der Basis der Erfassung der magnetischen Eigenschaften gleich nach der Schichtherstellung und einer entsprechenden Regelung. Vorteilhaft ist bei der Erfindung auch das Zusammenwirken von Aperturblende und Feldstärke im Magnetron. Ein weiterer Vorteil der Erfindung besteht darin, daß das Target über seine gesamte Oberfläche gleichmäßig zusammengesetzt ist, also kein Ringtarget aus einem anderen Material sein muß, wodurch die Lebensdauer des Targets verlängert wird.

Ausführungsbeispiele der Erfindung sind in der Zeichnung dargestellt und werden im folgenden näher beschrieben. Es zeigen:

Fig. 1 eine Magnetronkathode mit einer Magnetfeldregeleinrichtung;

Fig. 2 eine graphische Darstellung zur Erläuterung des magnetischen Verhaltens der seltenen Erden, der Übergangsmetalle sowie der Legierungen hiervon;

Fig. 3 die Abhängigkeit der Kompensationstemperatur von der Kathodenspannung sowie von der Breite S einer Aperturblende für ein neues Target;

Fig. 4 die Abhängigkeit der Kompensationstemperatur von der Kathodenspannung für ein erodiertes Target;

Fig. 5 die Abhängigkeit der Sputterrate von der Kathodenspannung.

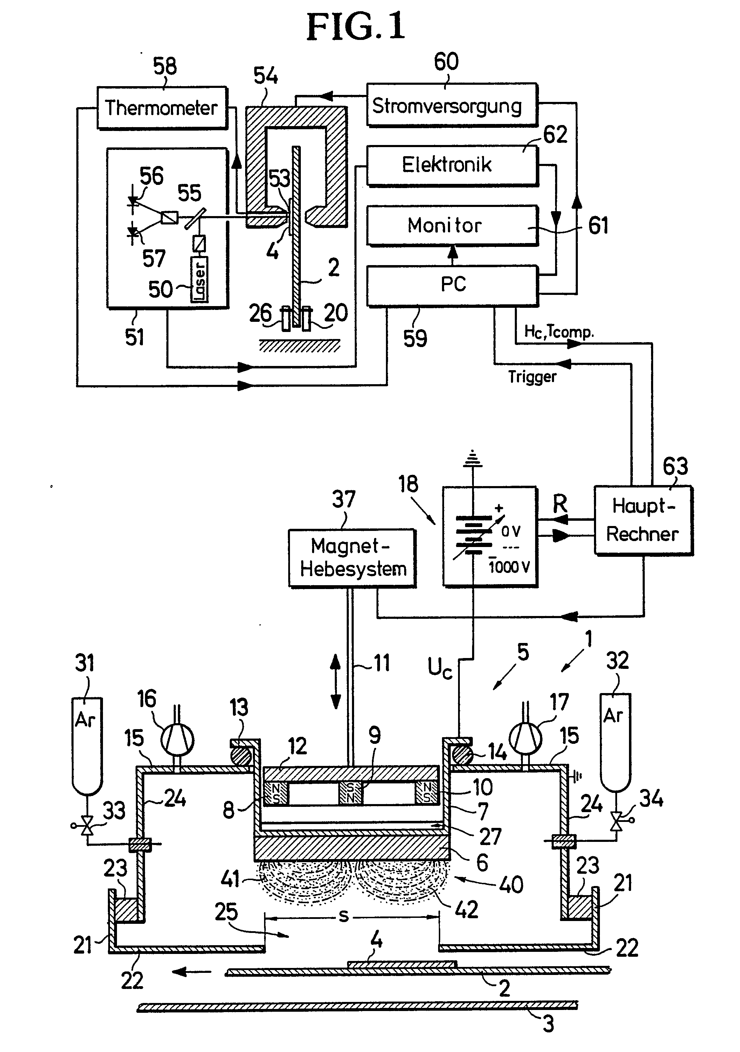

In der Fig. 1 ist eine Magnetronkathodenzerstäubungseinrichtung 1 dargestellt, die gegenüber einem Substratträger 2 angeordnet ist, hinter dem sich eine Abschirmung 3 befindet. Auf dem Substratträger 2 ist ein zu beschichtendes Substrat 4 angeordnet. Die Kathodenzerstäubungseinrichtung 1 weist eine Kathodenvorrichtung 5 auf, die ihrerseits die eigentliche Zerstäubungs- oder Targetkathode 6 und eine Kathodenwanne 7 besitzt. Oberhalb der Zerstäubungskathode 6, die z. B. aus einer Legierung aus seltenen Erden und Übergangsmetallen besteht, und in der Kathodenwanne 7 sind Permanentmagnete 8, 9, 10 vorgesehen, die durch ein gemeinsames Joch 2 abgeschlossen sind. Auf dem Boden der Kathodenwanne 7 ist ein Kühlkanal 27 für die Kühlung der Kathode vorgesehen. Die Magnete 8, 9, 10 an der Jochplatte 12 werden nicht gekühlt. Sie befinden sich in Umgebungsatmosphäre.

Die Kathodenwanne 7 besitzt einen flanschförmigen Rand 13, der unter Zwischenschaltung eines Isolators 14 in Form eine O-Rings mit der Decke 15 einer Kathodenkammer 28 verbunden ist, die an Massepotential liegt. Mit dieser Decke 15 sind auch eine oder mehrere Pumpen 16, 17 über große Saugquerschnitte verbunden, die ständig die Kathodenkammer 28 leerpumpen. Die Kathodenwanne 7 ist elektrisch mit dem negativen Pol einer regelbaren Gleichspannungsquelle 18 verbunden, die eine Gleichspannung von etwa 0 bis 1000 Volt liefert. Gegenüber der Zerstäubungskathode 6 befinden sich zwei senkrecht aufeinanderstehende Schenkel 21, 22, wobei der eine Schenkel 21 über ein elektrisch leitendes Verbindungsstück 23 mit einer Seitenwand 24 der Kathodenkammer 28 verbunden ist. Die Schenkel 21, 22 liegen somit ebenfalls an Massepotential.

Die Schenkel 22 weisen außerdem eine Öffnung 25 mit dem Durchmesser S auf und wirken somit als Blende. Diese Blende ist z. B. über das Verbindungsstück 23 austauschbar oder bezüglich ihres Durchmessers S regelbar, was in der Fig. 1 nicht näher dargestellt ist. Die Größe S der Blendenöffnung 25 hat einen Einfluß auf die Zusammensetzung der aufgesputterten Legierung.

Eine Voreinstellung über die Breite S der Aperturblende ist erforderlich, um über die gesamte Länge der Kathode und quer zur Transportrichtung gleichmäßige Kompensationstemperaturen zu erzeugen. Diese Voreinstellung wird während des Betriebs nicht verändert. Das für den Prozeß erforderliche Gas kommt aus Gasquellen 31, 32 und gelangt über Regelventile 33, 34 in die Kathodenkammer 28. Als Gas kommt beispielsweise Argon in Frage.

Fur die vorliegende Erfindung ist wesentlich, daß das Magnetfeld 40 des Magnetrons 1, das aus den beiden Teilfeldern 41, 42 besteht, verändert wird. Dies geschieht z. B. dadurch, daß an die Kathodenvorrichtung 5 ein regelbares Magnethebesystem 37 angeschlossen ist. Es sind jedoch auch andere Mittel denkbar, mit denen eine Magnetfeldänderung erzielt wird. Das Feld 40 des Magnetrons wird durch die Änderung der Position der Dauermagnete 8, 9, 10 mittels einer Stange oder dergleichen relativ zur Oberfläche des Targets 6 in seiner Stärke, nicht jedoch in seiner Geometrie geändert. Das Magnetfeld 40 der Kathode 7 bestimmt die Spannung, die von der Spannungsquelle 18 an die Kathode 7 gelegt wird.

Um die Bestandteile der aufgesputterten Legierung stets im gleichen Verhältnis zu halten, werden die magnetischen Eigenschaften der aufgetragenen Schichten fortwährend mittels eines Magnetometers gemessen.

Fur die Messung dieser Eigenschaften ist ein spezielles Kerrmagnetometer 51, 58 vorgesehen, das der besseren Übersichtlichkeit wegen im oberen Teil der Fig. 1 dargestellt ist, obwohl es in der Nähe des

4

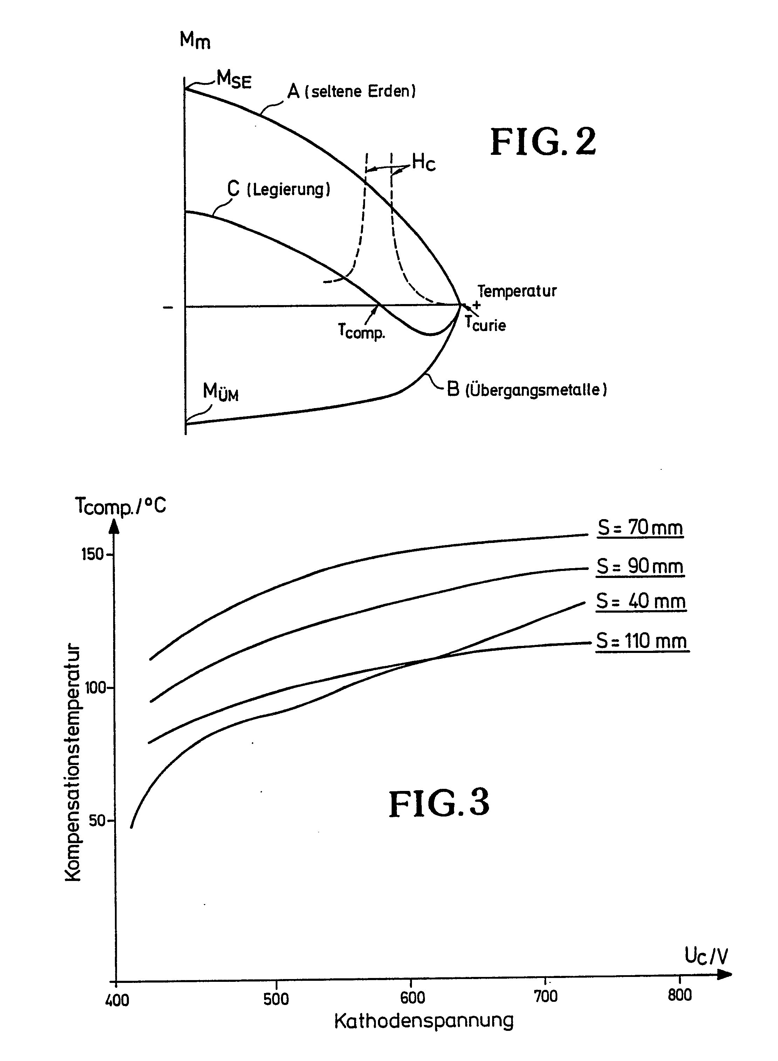

Substratträgers 2 angeordnet ist. Der Substratträger 2 mit dem Substrat 4 ist im oberen Teil der Fig. 1 noch einmal dargestellt. Das Kerrmagnetometer besteht aus einem Kopf 51, einem Thermometer 58 und einem Meßmagneten 54. In dem Kopf 51 befinden sich ein Laser 50 und eine Lichtmeßeinrichtung 55, 56, 57. Dieses Kerrmagnetometer vermißt die Kerr-Magnetisierungs kurve der produzierten Legierungsschicht auf dem Substrat 4 am Punkt 53. Der Träger 2 wird von zwei Antriebsrollen 20, 26 fortbewegt. Das Kerrmagnetometer 51, 58 wird von einem Personal Computer 59 gesteuert, der über eine Stromversorgung 60 das Magnetfeld des Meßmagneten 54 in vorwählbaren Schritten ändert. Bei jedem Schritt wird vom Personal Computer 59 die Kerrdrehung von polarisiertem, aus dem Laser 50 stammenden Licht, das auf einer Probenoberfläche des Trägers 2 reflektiert wird, registriert. Diese Registrierung erfolgt mit Hilfe eines Woolaston-Prismas 55 und zweier Photodioden 56, 57. Aus dem elektrischen Signal dieser beiden Dioden 56, 57 wird von einer Elektronik 62 der Polarisationsgrad des Meßlichts bestimmt. Der Personal Computer 59 ist, da gleichzeitig auch die Probentemperatur am Punkt 53 und dem optischen Thermometer 58 bestimmt wird, in der Lage, aus einem Fit für die Koerzitivfeldstärke die Kompensationstemperatur zu bestimmen. Sind diese Größen bekannt, so ist sofort ein Rückschluß auf die Zusammensetzung Legierung möglich. Der Wert für die Kompensationstemperatur wird einem Hauptrechner 63 zugeführt, de. den aktuellen Wert für $T_{comp}$ mit einem vorgegebenen und für das jeweilige Produkt gewünschten Wert vergleicht. Die Regelung erfolgt dann mit Hilfe des Magnethebesystems, das beispielsweise aus der DE-OS 30 47 113 oder der US-PS 4 426 264 bekannt ist, wobei die in den nachfolgend beschriebenen Figuren 3, 4, 5 gezeigten Abhängigkeiten berücksichtigt werden, d. h. das Magnethebesystem 37 fährt durch die Änderung der Position der Magnete 8, 9, 10 die Kathode 6 auf die entsprechende Spannung. Die Targetspannung ist dabei ein Maß für die Stärke des Magnetfelds an der Targetoberfläche.

Mit Hilfe eines Monitors 61 werden Informationen angezeigt, die für das Bedienungspersonal von Bedeutung sind. Hierbei handelt es sich z. B. um folgende Informationen: die gemessenen Magnetisierungskurven, die Koerzitivfeldstärke $H_c$, der Kerrwinkel, der Betriebszustand des Magnetometers und eventuell Daten eines früheren Produktionsvorgangs.

Aufgabe der Elektronik 62 ist es, die Signale der beiden Photodioden 56, 57 im Meßkopf 51 zu verstärken und die Größe

$$\frac{\text{Intensität}_{\text{Diode 56}} - \text{Intensität}_{\text{Diode 57}}}{\text{Summe der beiden Intensitäten}}$$

zu bilden, die ein direktes Maß für die Kerrdrehung der aufgesputterten Schicht ist, die der Person Computer 59 berechnet.

Der Hauptrechner 63 steuert die gesamte Beschichtungsanlage, wobei insbesondere die Steuerung de Kathodenspannung über das Magnethebesystem sowie die Steuerung der Kathodenleistungsdichte über die Sputterstromversorgung von Bedeutung sind.

Anhand der nachfolgenden Figuren werden die bereits erwähnten Abhängigkeiten zwischen Kathodenspannung $U_K$ einerseits und Kompensationstemperatur $T_{comp}$, Blendenspaltbreite S, Targeterosion und Sputterrate SR andererseits näher beschrieben.

In der Fig. 2 ist das magnetische Moment in Abhängigkeit von der Temperatur dargestellt. Die Kurve A zeigt hierbei das Verhalten der seltenen Erden. Man erkennt aus dieser Darstellung, daß das magnetische Moment der seltenen Erden bei niedrigen Temperaturen einen positiven Wert $M_{SE}$ einnimmt, der sehr hoch ist, und daß dieser Wert mit zunehmender Temperatur stetig abnimmt, um bei der Curietemperatur $T_{curie}$ den Wert Null anzunehmen.

Das magnetische Verhalten der Übergangsmetalle ist durch die Kurve B dargestellt. Auch hier sinkt das magnetische Moment $M_m$ von einem relativ hohen - allerdings negativen - Wert mit zunehmender Temperatur bis zum Wert Null bei der Curietemperatur $T_{curie}$.

Wesentlich ist nun, daß die magnetischen Momente der seltenen Erden und der Übergangsmetalle entgegengesetzte Vorzeichen haben. Hierdurch ergibt sich bis zur Kompensationstemperatur $T_{comp}$ ein Gesamtverhalten der Legierung, das von den seltenen Erden dominiert wird, und von da an ein Verhalten, bei dem die Übergangsmetalle dominieren. Dieses Gesamtverhalten wird durch die Kurve C dargestellt. Es ist das Verhalten ferrimagnetischer Systeme. Die Legierung zeigt somit bei $T_{comp}$ nach außen ein Verhalten wie bei der Curietemperatur $T_{curie}$, obwohl die magnetische Ordnung der Domänen der einzelnen Legierungskomponenten noch nicht zerstört ist.

Bei der Kompensationstemperatur $T_{comp}$ hat die Koerzitivfeldstärke $H_c$ eine Polstelle, d. h. sie nimmt zu beiden Seiten von $T_{comp}$ den Wert Unendlich an, da bei dieser Temperatur die Magnetisierung verschwindet, die Energiedichte $M_s$ . $H_c$ aber erhalten bleibt. Wenn diese Kompensationstemperatur $T_{comp}$ auf den Wert der Umgebungstemperatur gebracht wird, bedeutet dies also, daß bei Umgebungstemperatur keine Informationen gelöscht werden können. Dies ist ein erwünschter Zustand, weshalb es sinnvoll ist, die Zusammensetzung der Legierung so zu wählen, daß $T_{comp}$ der Umgebungstemperatur entspricht.

Die Abhängigkeiten der charakteristischen Kompensationstemperaturen $T_{comp}$ sowie der Curietemperatur $T_{curie}$ einer Legierung von der Zusammensetzung der Legierung sind relativ steil. So ergibt sich z. B. für die ternäre Legierung TbFeCo die Kompensationstemperatur aus

$$T_{comp} (°C) = 25 + (x - 23) . 40$$

und die Curietemperatur aus

$$T_{curie} (°C) = 135 + 8 . y$$

wobei x der Terbium-, y der Cobaltanteil in Atomprozent in der Schichtzusammensetzung sind.

Dies bedeutet, daß bei einer Änderung der Terbium- bzw. Cobaltanteile in der Schicht um ein Atomprozent sich die Kompensationstemperatur um 40 °C bzw. die Curietemperatur um 8 °C verschiebt.

Das Sputterverhalten magnetooptischer Targets läßt sich dahingehend interpretieren, daß die Einzelelemente der Target-Legierung unterschiedliche Winkelverteilungen vor der Rennbahn des Magnetrons besitzen. Die Sputterteilchen der seltenen Erden sind dabei stärker seitlich ausgedehnt oder stärker im Zentrum konzentriert als die Übergangsmetalle. Wird die Umgebungsgeometrie der Kathode entsprechend angepaßt, können äußere Teile des Teilchenflusses zum Substrat ausgeblendet werden. Da eine Änderung des Magnetfelds der Kathode die Plasmageometrie verändert, läßt sich der ausgeblendete Teil steuern. Dies ist die Grundlage des erfindungsgemäßen Regelprinzips, da die Schichtzusammensetzung entsprechend variiert.

In der Fig. 3 ist die Abhängigkeit der Kompensationstemperatur $T_{comp}$ für ein $Tb_{0,24}Fe_{0,68}Co_{0,08}$-Target von der Target- oder Kathodenspannung $U_K$ dargestellt, wobei die verschiedenen Kurven die Breiten S der Öffnung 25 (Fig. 1) darstellen. Man erkennt aus dieser Darstellung, daß die Kompensationstemperatur $T_{comp}$ mit zunehmender Targetspannung sowie mit abnehmender Spaltbreite zunimmt. Hierbei ist stets ein frisches Target angenommen. Die Fig. 3 läßt außerdem erkennen, daß eine Änderung des Magnetfelds der Magnetronkathode 6 zu kleineren Feldstärken führt, was durch höhere Kathodenspannungen angedeutet ist. Dies wiederum führt zum Ansteigen des Seltenerdanteils in der hergestellten Legierung. Da die Magnetfeldstärken-Kompensationstemperaturcharakteristik auch eine Funktion der Aperturblendenbreite S ist, kann durch Änderung dieser Aperturblendenbreite S eine Grobeinstellung der Kompensationstemperatur der hergestellten Legierungsschichten erfolgen, während die Änderung des Magnetfelds feinere Verschiebungen ermöglicht. Bei gegebener Zerstäubungs- oder Kathodenspannung ergibt sich für jede Spaltbreite eine unterschiedliche Kompensationstemperatur. Ist der normale Regelbereich erschöpft, so kann man gegebenenfalls auf eine andere Blendenbreite S umstellen. Da die Kathodenspannung ein Maß für die Stärke des Magnetfelds an der Targetoberfläche ist, kann die Spannungsachse der Fig. 3 auch als Magnetfeldstärkenachse aufgefaßt werden.

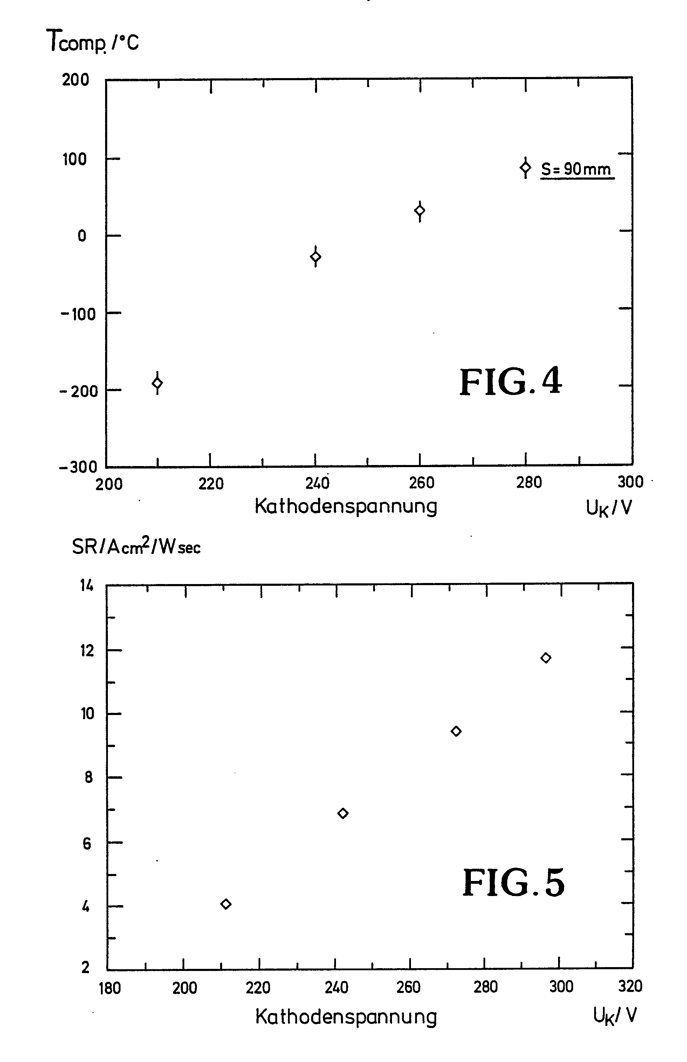

Die Fig. 4 zeigt die Abhängigkeit der Kompensationstemperatur $T_{comp}$ von der Kathodenspannung $U_K$ bei konstantem Spalt S der Abschirmung 22 und bei erodiertem Target. Die Targeterosion ist dabei zu 50 % angenommen. Man erkennt hieraus, daß sich im Verlauf der Targeterosion die Abhängigkeit der Kompensationstemperatur $T_{comp}$ von der Kathodenspannung $U_K$ ändert. Anders als bei der Darstellung der Fig. 3 handelt es sich hier nicht stets um ein frisches Target. Die praktische Konsequenz hieraus ist, daß bei der Produktion tatsächlich fortwährend gemessen und nachgeregelt werden muß. Gegenüber der Regelung nur auf der Basis der aktuellen Kathodenspannung läßt sich die Targetlebensdauer erheblich verlängern, was sehr wichtig ist, denn magnetooptische Targets sind sehr teuer.

In der Fig. 5 ist die Abhängigkeit der spezifischen Sputterrate von der Kathodenspannung $U_K$ dargestellt. Man erkennt hieraus, daß die Sputterrate mit wachsender Spannung zunimmt. Die Änderung des Magnetfelds der magnetooptischen Kathode führt somit auch zu einer Änderung der spezifischen Rate. Da aber eine Änderung der Leistungsdichte auf dem Target 6, d. h. bei fester Kathodenspannung der Kathodenstroms, die magnetischen Eigenschaften der Legierungsschichten nicht verändert, kann diesem Problem durch Nachregelung des Kathodenstroms mittels des Hauptrechners 63 Rechnung getragen werden.

Es wäre auch denkbar, die Kompensationstemperatur in Abhängigkeit vom Hub des Magnethebesystems darzustellen. Dies würde jedoch zu einer sehr komplexen Darstellung führen, weil die Kathodenkonstruktionen durchaus auch unterschiedlich sind. Da jedoch zwischen der Zerstäubungs-oder Kathodenspannung und der Spindeleinstellung bzw. dem Abstand der Magnete 8, 9, 10 von der ursprünglichen Oberfläche des Targets 6 ein proportionaler Zusammenhang besteht und die Kathodenspannung während des Betriebs sehr zuverlässig gemessen werden kann, wie z. B. aus der US-PS 4 426 264 hervorgeht, wurde als Ausgangsgröße die Kathodenspannung gewählt. Sofern der Wert der Kathodenspannung durch Regelung konstant gehalten wird, ergibt sich auch eine konstante Kompensationstemperatur. Dies gilt auch für unterschiedliche Konstruktionen von Magnetronkathoden.

Je nachdem, ob die mittels des sich innerhalb einer Vakuumbeschichtungsanlage befindlichen Magnetometers gemessene Kompensationstemperatur dem gewünschten Wert entspricht oder nicht, kann anhand eines Diagramms oder mittels eines Rechners bestimmt werden, in welcher Weise die Kathodenspannung verändert werden muß, was dann wiederum über den Regler durch Verstellung des Magnetabstands geschieht. Es handelt sich dabei um eine geschlossene Regelschleife.

## Ansprüche

1. Verfahren zur Herstellung magnetooptischer, speicher- und/oder löschfähiger Datenträger unter Verwendung verschiedener chemischer Stoffe, wobei diese Stoffe mittels einer Magnetron-Sputter-Anlage als Schichten auf ein Substrat aufgebracht werden, **dadurch gekennzeichnet**, daß die chemische Zusammensetzung der Schichten durch die jeweilige Einstellung des Magnetfelds des Magnetrons (1) festgelegt wird.

2. Verfahren zur Herstellung magnetooptischer, speicher- und/oder löschfähiger Datenträger unter Verwendung verschiedener chemischer Stoffe, wobei diese Stoffe mittels einer Magnetron-Sputter-Anlage als Schichten auf ein Substrat aufgebracht werden, **dadurch gekennzeichnet**, daß die chemische Zusammensetzung der Schichten durch die Veränderung der Größe (S) einer Aperturblende (22) des Magnetrons (1) festgelegt wird.

3. Einrichtung zur Herstellung magnetooptischer, speicher- und/oder löschfähiger Datenträger oder dergleichen unter Verwendung verschiedener chemischer Stoffe, wobei diese Stoffe mittels einer Magnetron-Sputter-Anlage als Schichten auf ein Substrat aufgebracht werden, **dadurch gekennzeichnet**, daß eine Meßeinrichtung (51, 58) vorgesehen ist, welche die magnetischen Eigenschaften der auf das Substrat (4) aufgesputterten Schicht mißt und die Parameter der Einrichtung in Abhängigkeit von diesen magnetischen Eigenschaften einstellt.

4. Einrichtung nach Anspruch 3, **dadurch gekennzeichnet**, daß für die Messung der magnetischen Eigenschaften der auf das Substrat (4) aufgesputterten Schicht ein Kerrmagnetometer (51, 58, 54) vorgesehen ist.

5. Einrichtung nach Anspruch 4, **dadurch gekennzeichnet**, daß mittels des Kerrmagnetometers (51, 54, 58) die Koerzitivfeldstärke ($H_c$) der aufgesputterten Schicht ermittelt wird.

6. Einrichtung nach Anspruch 5, **dadurch gekennzeichnet**, daß mittels eines Thermometers (58) die Temperatur der aufgesputterten Schicht ermittelt wird.

7. Einrichtung nach den Ansprüchen 4 bis 6, **dadurch gekennzeichnet**, daß mittels einer Datenverarbeitungseinrichtung (59) aus der Temperatur und der Koerzitivfeldstärke der aufgesputterten Schicht die Kompensationstemperatur bestimmt wird.

8. Einrichtung nach den Ansprüchen 4 bis 7, **dadurch gekennzeichnet**, daß eine Regeleinrichtung vorgesehen ist, welche eine vorgegebene Kompensationstemperatur mit der aktuellen Kompensationstemperatur vergleicht und die Parameter der Einrichtung so verändert, daß die aktuelle Kompensationstemperatur der vorgegebenen Kompensationstemperatur angeglichen wird.

9. Einrichtung nach Anspruch 8, **dadurch gekennzeichnet**, daß die vorgegebene Kompensationstemperatur einer Legierung gleich der Umgebungstemperatur ist.

10. Verfahren nach den Ansprüchen 1 oder 2, **dadurch gekennzeichnet**, daß die chemischen Stoffe binäre, ternäre oder quaternäre Legierungen aus einerseits den Elementen der Seltenerdgruppen ($^{59}$Pr - $^{70}$Yb) und andererseits aus Elementen der Übergangsmetallgruppen ($^{26}$Fe - $^{28}$Ni) sind.

11. Verfahren nach den Ansprüchen 1 oder 2, **dadurch gekennzeichnet**, daß die chemischen Stoffe in Form eines amorphen Dünnfilms auf ein Substrat (4) aufgebracht werden.

12. Verfahren nach Anspruch 11, **dadurch gekennzeichnet**, daß der amorphe Dünnfilm durch Al, AlN oder $Si_3N_4$ abgedeckt wird.

13. Einrichtung nach Anspruch 3, **dadurch gekennzeichnet**, daß die Targetspannung (18, 37) über das Magnetfeld des Magnetrons (1) verändert wird.

14. Verfahren nach Anspruch 2, **dadurch gekennzeichnet**, daß die Aperturblende (22) in der Umgebung der Kathode (6, 7) vorgesehen ist.

15. Verfahren nach Anspruch 10, **dadurch gekennzeichnet**, daß die Legierung aus 68 % Eisen, 8 % Kobalt und 24 % Terbium besteht.

16. Einrichtung nach Anspruch 3, **dadurch gekennzeichnet**, daß die Kathode (6, 7) des Magnetrons (1) eine Rechteckkathode ist und daß kreisscheibenförmige Substrate (4) auf einem ebenen Substratträger (2) horizontal und im rechten Winkel zur längsten Kathodenachse unter dieser Kathode (6, 7) vorbeitransportiert werden.

17. Einrichtung nach Anspruch 16, **dadurch gekennzeichnet**, daß die Magnete (8, 9, 10) des Magnetrons (1) mit einem regelbaren Magnethebesystem (37) verbunden sind.

18. Einrichtung nach Anspruch 17, **dadurch gekennzeichnet**, daß die Regelung des Magnethebesystems (37) unter Berücksichtigung eines vorgegebenen Wertes für die Kompensationstemperatur $T_{comp}$ erfolgt.

19. Einrichtung nach Anspruch 18, **dadurch gekennzeichnet**, daß eine Meßvorrichtung (50 bis 62) für die Ermittlung der Kompensationstemperatur vorgesehen ist und daß eine Regeleinrichtung (37, 63) vorgesehen ist, welche die Kompensationstemperatur $T_{comp}$ dem vorgegebenen Wert angleicht.

20. Einrichtung nach Anspruch 3, **dadurch gekennzeichnet**, daß ein Magnetron mit wenigstens einer Zerstäubungskathode (6) und zwei Dauermagneten (8, 9 bzw. 9, 10) vorgesehen ist, wobei der positive Pol des einen Dauermagneten (z. B. 9) mit dem negativen Pol des anderen Dauermagneten (z. B. 8) Feldlinien ausbildet, die sich in Richtung auf ein Substrat (4) erstrecken, daß eine Meßeinrichtung (51, 58) für die Erfassung der magnetischen Eigenschaften an einem Punkt des Substrats (4) vorgesehen ist, daß der Abstand der Dauermagnete (8, 9 bzw. 9, 10) von dem Substrat (4) sowie die an die Kathode gelegte Spannung $U_K$ in Abhängigkeit von den gemessenen magnetischen Eigenschaften geregelt werden.

21. Einrichtung nach Anspruch 20, **dadurch gekennzeichnet**, daß die Spannung $U_K$ einer regelbaren Stromversorgung (18) entnommen wird, deren Strom oder Leistung ebenfalls regelbar sind.

22. Einrichtung nach Anspruch 3, mit
a) einer Sputteranlage mit einer Targetplatte (6), von deren einer Seite Material gesputtert wird;
b) einer Magneteinrichtung (8, 9, 10, 12) auf der einen Seite der Targetplatte (6), um wenigstens einige Magnetfeldlinien vorzusehen, die von einer Seite in die Targetplatte (6) eintreten und auf dieser wieder heraustreten;
c) einer Positioniereinrichtung (37), welche den Abstand zwischen der Targetplatte (6) und der magnetischen Einrichtung (8, 9, 10, 12) verändert, um das magnetische Feld, das auf der einen Seite der Targetplatte (6) eintritt und auf dieser Seite wieder austritt, zu verändern, wobei im wesentlichen konstante Sputterparameter beibehalten werden, **dadurch gekennzeichnet**, daß mit Hilfe der Positioniereinrichtung (37) ein bestimmter Kathodenspannungswert ($U_K$) angefahren wird, der im Laufe der Targeterosion oder um das magnetische Verhalten der aufgesputterten Schichten zu beeinflussen, geändert wird.

23. Einrichtung nach einem oder nach mehreren der vorangegangenen Ansprüche, **dadurch gekennzeichnet**, daß die Aperturblende aus zwei langgestreckten Blechstreifen (21, 22) besteht, deren längste Achsen parallel zur Kathodenlängsachse verlaufen.

FIG.1

FIG. 2

FIG. 3

FIG.4

FIG.5